# EUROPEAN PATENT SPECIFICATION

(11) **EP 3 896 693 B1**
(45) Date of publication and mention of the grant of the patent: **25.10.2023**
(21) Application number: 19947164.0
(22) Date of filing: 27.11.2019
(51) Int. Cl.: G11C 29/24, G11C 11/408, G11C 11/4063, G11C 8/06, G11C 29/00

(54) **MEMORY AND ADDRESSING METHOD THEREFOR**
SPEICHER UND ADRESSIERUNGSVERFAHREN DAFÜR
MÉMOIRE ET SON PROCÉDÉ D'ADRESSAGE

(30) Priority: 24.09.2019 CN 201910904486
(43) Date of publication of application: 20.10.2021
(73) Proprietor: Changxin Memory Technologies, Inc., Anhui 230000 (CN)
(72) Inventor: SHANG, Weibing, Hefei, Anhui 230000 (CN); ZHANG, Liang, Hefei, Anhui 230000 (CN); WANG, Jia, Hefei, Anhui 230000 (CN)
(74) Representative: Lavoix
(86) International application number: PCT/CN2019/121162
(87) International publication number: WO 2021/056804

(56) References cited:
- CN-A- 105 513 646
- CN-A- 109 841 260
- CN-U- 210 606 641
- US-A- 5 434 814
- US-A- 5 434 814
- US-A- 5 808 948
- US-A- 5 953 267
- US-B1- 6 208 570
- US-B1- 6 304 498

## Description

### TECHNICAL FIELD

The present disclosure relates to the technical field of memory, and in particular to a memory and an addressing method therefor.

### BACKGROUND

In the design of Dynamic Random Access Memories (DRAMs), redundant cells are generally added internally to repair defective row storage locations and column storage locations at normal storage locations that occur during the manufacturing process.

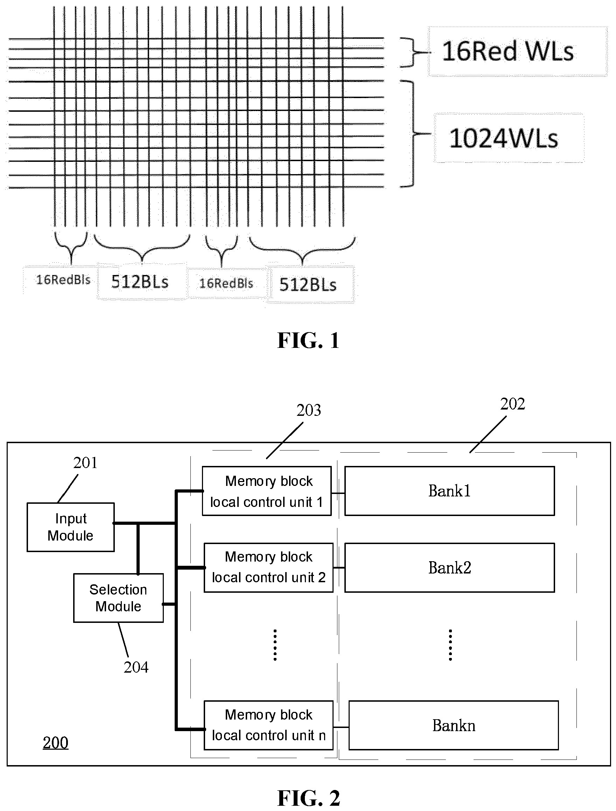

FIG. 1 is a schematic diagram of the layout positions of normal and redundant storage units in an existing DRAM.

FIG. 1 merely shows word lines (WL) and bit lines (BL). Among them, 16 rows of redundant storage units are set for every 1,024 horizontal word lines (WLs), corresponding to 16 redundant word lines (RedWLs), and 16 columns of redundant storage units are set for every 512 vertical bit lines BLs, corresponding to 16 redundant bit lines (RedBLs).

In the memory chip testing phase, normal storage units need to be accessed to test whether each normal storage unit is valid. If a normal storage unit is invalid, the address of the invalid storage unit needs to be recorded, and a redundant storage unit is used instead of the invalid storage units for data storage.

Therefore, in the chip test phase, it is necessary to test the normal storage units and the redundant storage units, respectively. Because the addresses of the normal storage units and the redundant storage units use different decoding modes, in the related art, the normal storage units and the redundant storage units are usually tested separately to access the corresponding address through different test paths and timing controls. During the test, it is necessary to switch frequently between the two tests. This switch increases the testing time. In addition, the difference in the test paths and the timing controls also easily introduces human test error, resulting in a decrease in test accuracy.

Therefore, it is necessary to improve the memory addressing test efficiency in the related art.

US6208570B1 discloses a semiconductor memory device having a redundancy test scheme. A memory cell array includes a normal section and a redundant section of memory cells. In a normal mode of operation, the redundant section is selected if an applied address corresponds to a defective bit in the normal section. In a redundant test mode of operation, the redundant section is selected based on a redundant test address. If the redundant test address is in the normal select logic level, a normal decode section is selected. The redundant test address and a redundant test activation signal are applied to a redundant decoder. If the redundant test address is in a redundant select logic level and the redundant test activation signal is active, the redundant decoder is selectable based on the applied address value.

US5808948A provides a semiconductor memory device which does not require an additional input pad to apply a signal for discriminating between a normal cell and a redundant cell. The normal cell array or the redundant cell array is sequentially selected and tested by using the same input pad to which the bank select bit is input, without an additional pad.

### SUMMARY

The present invention is set out in the appended set of claims. The disclosure provides a memory and an addressing method therefor to improve the test efficiency of the memory.

The memory of the present disclosure can control address or command input signal to perform the corresponding redundant decoding or normal decoding, by setting the decoding selection instruction, the test process is made more flexible without having to switch the signal input interface. The path and timing of the address signal input are consistent with the generating path and timing of the first enable signal. As a result, human test errors can be reduced, thereby improving the test accuracy and convenience.

### BRIEF DESCRIPTION OF THE DRAWINGS

FIG. 1 is a schematic structural diagram of an existing memory array as per an aspect not being part of the invention;
FIG. 2 is a schematic structural diagram of a memory according to some embodiments of the present invention;
FIG. 3 is a schematic structural diagram of a memory according to some embodiments of the present invention;
FIG. 4 is a schematic structural diagram of a memory according to some embodiments of the present invention; and
Fig. 5 is a memory addressing method according to some embodiments of the present invention.

### DETAILED DESCRIPTION

The specific implementation of a memory and its addressing method therefor according to the embodiments of the present disclosure will be described in detail with reference to the accompanying drawings in the following paragraphs.

FIG. 2 is a schematic structural diagram of a memory according to some embodiments of the present invention.

The memory 200 includes: an input module 201, a memory array 202, a control module 203, and a selection module 204.

The memory array 202 includes multiple memory blocks (Banks), such as Bank1, Bank2, ... to Bankn. Each Bank includes multiple memory units distributed in an array, and each memory unit has a row address and a column address. Therefore, each memory unit in the memory array 202 has a block (Bank) address, a row address, and a column address. When addressing the memory unit, firstly, the memory block where the memory unit is located is found according to the block address, and then the specific location of the memory unit in the memory block is found according to the row address and column address. Each memory block includes normal memory units and redundant memory units arranged in an array. The address decoding of the normal memory units and the address decoding of the redundant memory units require different decoding modes respectively.

The input module 201 is configured to receive an address or command input signal including an address, a command, and a decoding selection instruction. The access address includes a block address, a row address, and a column address. The decoding selection instruction corresponds to the address decoding mode, and is used to instruct redundant decoding or normal decoding of the address.

The control module 203 includes a plurality of memory block local control units, for example, memory block local control unit 1~memory block local control unit n, respectively, connected to the corresponding memory block Bank1~memory block Bankn; the memory block local control units are configured to decode address or command input signals with corresponding block addresses to select the memory unit corresponding to the access address.

The input module 201 is connected to the control module 203. The address or command input signal received by the input module 201, after being processed, is input to the memory block local control unit corresponding to the block address in the control module 203 for decoding. The memory block local control unit includes: at least one decoding unit, configured to perform redundant decoding or normal decoding on the address or command input signal, the input of the decoding unit is coupled to the input module, and the output of the decoding unit is coupled to the memory block. Generally, each memory block local control unit includes two decoding units, a row decoding unit for row address decoding, and a column decoding unit for column address decoding.

The input of the selection module 204 is coupled to the input module 201, and the output of the selection module 204 is coupled to the decoding unit in the memory block local control unit, and is configured to output, according to the address or command input signal, a first enable signal to the decoding unit in the corresponding memory block local control unit, to control the decoding unit to perform redundant decoding or normal decoding on the address or command input signal.

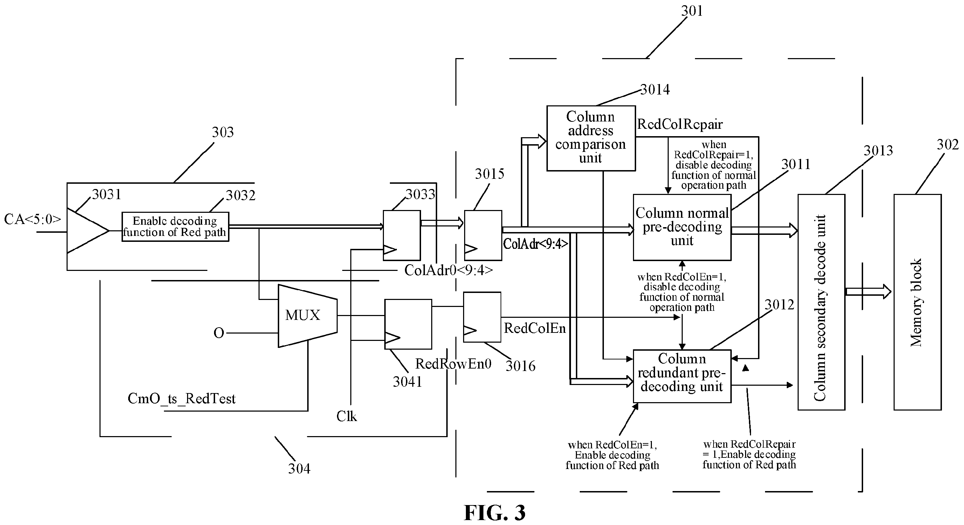

FIG. 3 is a schematic structural diagram of the memory according to some embodiment of the present invention.

In FIG. 3, merely the circuit structure related to the column decoding part is shown.

The input module 303 includes: an input interface, a buffer unit 3031 coupled to the input interface, and a logic control unit 3032 coupled to an output of the buffer unit 3031 and a normal address latch unit 3033 coupled to an output of the logic control unit 3032.

In this specific implementation, taking LPDDR4 as an example, the input interface includes 6 pins, which are pins CA0~CA5, for inputting high and low electric signals to form a set of digital signals as the address or command input signal CA<5:0>. A complete address or command input signal can be input through one input or multiple inputs. The address or command input signal includes information such as a block address, a column address, a row address, and a command. The command can be operation instructions such as decoding the row address or the column address, a reading operation and a writing operation, or refresh. The address or command input signal CA<5:0> also includes a decoding selection instruction, the decoding selection instruction is configured to select redundant decoding or normal decoding on the address or command input signal.

It is usually necessary to transmit multiple sets of digital signals at multiple clock edges to achieve the transmission of the complete commands and address information, thus forming a complete address or command input signal. Among the address or command input signal input at a specific clock edge, there is an input signal from a pin that is useless for address and command information, for example, the input pin CA3 of LPDDR4 is not used as a command or address input at a certain clock edge. Therefore, according to the embodiment of the present disclosure, a decoding selection command can be sent to the specific clock edge, and the decoding selection command received by pin CA3 at the specific clock edge is only used as a selection command for the subsequent decoding mode, and will not impact the final address decoding result.

In the specific embodiment of the present disclosure, when one of the pins of the input interface is not used as a valid address or command input pin at a certain clock edge, the pin is used to input the decoding selection command at the clock edge, thereby there is no need to add additional pins for the decoding selection instruction, and also there is no need to change the timing and path of the address or command input signal, thus realizing flexible and efficient decoding mode selection.

According to the embodiment, the address or command input signal CA<5:0>, after passing through the buffer unit 3031 and being subjected to logic process by the logic control unit 3032, is sent to the normal address latch unit 3033 to latch the required column address signal ColAdrO<9:4>, and later the column address signal ColAdrO<9:4> is sent to the memory block local control unit 301 corresponding to the memory block address in the address or command input signal to perform column address decoding.

In another embodiment according to the present disclosure, the specific structure of the input module 303 may include technical variations known to those of ordinary skills in the art and will not be described in detail here.

In the above embodiment, the memory block local control unit 301 includes a column decoding unit, and the memory block 302 is coupled to the output of the column secondary decoding unit 3013. The memory unit corresponding to the access address is selected according to the decoded access address output by the column secondary decoding unit 3013.

The column decoding unit further includes a column normal pre-decoding unit 3011, a column redundant pre-decoding unit 3012, and a column secondary decoding unit 3013; and the outputs of the column redundant pre-decoding unit 3012 and the column normal pre-decoding unit 3011 are both coupled to the input of the column secondary decoding unit 3012. After column redundant decoding or column normal pre-decoding, the address or command input signal is input to the column secondary decoding unit 3013 for secondary decoding to obtain the final column address information. For example, the column address of the normal memory unit is obtained by decoding by the column normal pre-decoding unit 3011 and the column secondary decoding unit 3013, so that a column memory unit in the memory block 302 corresponding to the column address can be selected. For another example, after decoding by the column redundant pre-decoding unit 3012 and the column secondary decoding unit 3013, the column address of the redundant memory unit is obtained, so that a column redundant memory unit in the memory block 302 corresponding to the column address can be selected.

According to the embodiment, the memory block local control unit 301 further includes a first local latch unit 3015, the input of the first local latch unit 3015 is coupled to the output of the normal address latch unit 3033, the output of the first local latch unit 3015 is coupled to the inputs of the column redundant pre-decoding unit 3012 and the column normal pre-decoding unit 3011.

After the column address signal ColAdrO<9:4> output from the normal address latch unit 3033 passes through the first local latch unit 3015, it is output to the column redundant pre-decoding unit 3012 and the column normal pre-decoding unit 3011.

The memory further includes a selection module 304, and the output of the selection module 304 is coupled to both the enable terminals of the column redundant pre-decoding unit 3012 and the enable end of the column normal pre-decoding unit 3011. The input of the selection module 304 is coupled to the input module 303 and is configured to receive the decoding selection instruction in the address or command input signal at the corresponding clock edge, and to control the column redundant pre-decoding unit 3012 to be enabled or control the column normal pre-decoding unit 3011 to be enabled according to the decoding selection instruction in the address or command input signal.. For example, if the decode selection instruction is 1 (high level), the selection module 304 outputs the first enable signal RedColEn=1, which controls the column redundant pre-decoding unit 3012 to be enabled, to perform column redundant decoding on the address or command input signal ColAdrO<9:4>, in order to obtain the column address of the redundant memory unit. If the decoding selection instruction is 0 (low level), the selection module 304 outputs the first enable signal RedColEn=0, which controls the column normal pre-decoding unit 3011 to be enabled to perform column normal decoding on the address or command input signal ColAdrO<9:4>, in order to obtain the column address of the normal memory unit.

The selection module 304 includes: a multiplexer MUX, the first input of the multiplexer MUX is coupled to the input module 303; the second input of the multiplexer MUX is connected to a reference level, the reference level is low level 0. The control terminal of the selection module 304 is connected to a test control signal Cm0_ts_RedTest, and the test control signal, Cm0_ts_RedTest, is configured to control the multiplexer MUX to output a signal corresponding to the first input or the second input. The selection module 304 further includes a test enable latch unit 3041, and the input of the test enable latch unit 3041 is coupled to the output of the multiplexer MUX.

When the test control signal, Cm0_ts_RedTest=1, the multiplexer MUX outputs the decoding selection instruction input by the first input to the test enable latch unit 3041. The first enable signal RedColEnO output by the test enable latch unit 3041 is output to the memory block local control unit 301 for enabling the column normal pre-decoding unit 3011 or the column redundant pre-decoding unit 3012.

The memory block local control unit 301 also includes a second local latch unit 3016. The input of the second local latch unit 3016 is coupled to the output of the selection module 304 for latching the first enable Signal RedColEnO; the output of the second local latch unit 3016 is coupled to the enable terminals of the column redundant pre-decoding unit 3012 and the column normal pre-decoding unit 3011.

After the address or command input signal input through the input module 303 passes through the buffer unit 3031 and the logic control unit 3032, the normal address memory 3033 latches the required address information ColAdr<9:4>; at the same time, the selection module 304 outputs the first enable signal RedColEnO based on the obtained decoding selection instruction in the address or command input signal. The column address signal ColAdr<9:4> and the first enable signal RedColEnO reach the memory block local control unit 301 respectively, then are latched by the first local latch r unit 3015 and the second local latch unit 3016 respectively. When the second local latch unit 3016 outputs the first enable signal RedColEn=1, the decoding of the normal path is stopped, and the column redundant pre-decoding unit 3012 is enabled; when the first enable signal RedColEn=0,the column redundant pre-decoding unit 3012 is stopped, and the normal decoding path will not be affected. In a specific implementation, when the decode selection instruction is 1, the first enable signal RedColEn=1; and when the decode selection instruction is 0, the first enable signal RedColEn=0.

When performing column test on redundant memory units and normal memory units, by setting the decoding selection instruction, the memory block local control unit 301 can be controlled to perform corresponding redundant decoding or normal decoding, thereby making the testing process more flexible. There is no need to switch the signal input interface.

When switching between the normal memory unit and the redundant memory unit test, only the decoding selection instruction needs to be controlled. Each latch unit is controlled by the same clock signal, CLK, so the control timings and the paths of the column address signal ColAdrO<9:4> and the first enable signal RedColEn are completely consistent with each other, which can reduce human test errors, thereby improving the accuracy and convenience of the test.

According to the embodiment, the local memory block control unit 3014 further includes a column address comparison unit 3014, the input of the column address comparison unit 3014 is coupled to the input module 303, and the output of the column address comparison unit 3014 is coupled to the enable terminals of the column normal pre-decoding unit 3011 and the column redundant pre-decoding unit 3011.

The address comparison unit 3014 is configured to store the defective address information acquired during the test. When performing normal reading and writing operations on the memory, the address comparison unit 3014 compares the column address signal ColAdr<9:4> with the defective address information; outputs a second enable signal RedColRepair based on a result of the comparison, in order to control the decoding unit to perform corresponding redundant decoding or normal decoding on the address or command input signal. Specifically, when the access address matches the defective address, the second enable signal RedColRepair=1, the access address is invalid, so as to enable the column redundant pre-decoding unit 3012 to perform column redundant pre-decoding on the input signal, to obtain the column address of the redundant memory unit that replaces the defective address. When the access address does not match the defective address, the access address is valid. When the second enable signal RedColRepair=0, it enables (Enable) the column normal pre-decoding unit 3011, to perform column normal pre-decoding 3011 on the input signal to obtain the column address of the normal memory unit.

When performing normal reading and writing operations on the memory, the test control signal, Cm0_ts_RedTest=0, can be set so that the selection module 304 would not obtain the decoding selection instruction, therefore stopping the selection function of the selection module 304 for the redundant decoding path.

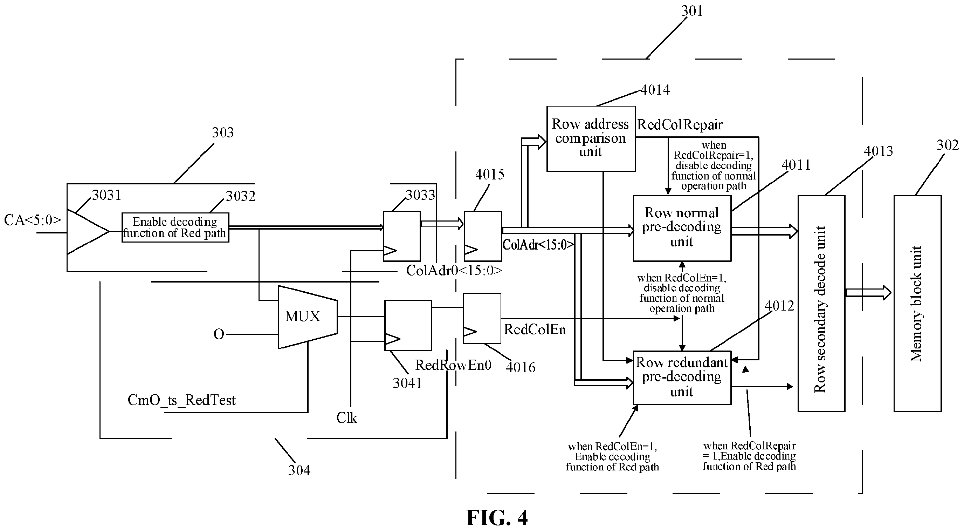

Please refer to FIG. 4, which is a schematic structural diagram of a memory according to another embodiment of the present invention.

FIG. 4 merely shows a schematic diagram of a circuit structure related to the row decoding.

The input module 303 includes: an input interface, a buffer unit 3031 coupled to the input interface, a logic control unit 3032 coupled to the output of the buffer unit 3031, and a normal address latch unit 4033 coupled to the output of the logic control unit 3032. The address or command input signal CA<5:0> , after being buffered by the buffer unit 3031 and processed by the logic control unit 3032, is sent to the normal address latch unit 3033 to latch the desired row address signal RowAdrO <15:0>, and then the row address signal RowAdr0<15:0> is sent to the row decoding unit in the local control unit 301 of the memory block corresponding to the block address in the address or command input signal to decode the row address.

The row decoding unit in the memory block local control unit 301 includes: a row normal pre-decoding unit 4011, a row redundant pre-decoding unit 4012, and a row secondary decoding unit 4013. The outputs of row redundant pre-decoding unit 4012 and the the row normal pre-decoding unit 4011 are both coupled to the inputs of the row secondary decoding unit 4012, and the address or command input signal, after being subjected to row redundant decoding or row normal pre-decoding, is input to the row secondary decoding unit 4012 redundant decodingfor secondary decoding, to obtain the final row address information.

According to the embodiment, the memory block local control unit 301 further includes a first local latch unit 4015, which is configured to locally latch the row address signal RowAdr0<15:0>. The input of the first local latch unit 4015 is coupled to the output of the normal address latch unit 3033, and the output of the first local latch unit 4015 is coupled to the inputs of the row redundant pre-decoding unit 4012 and the line normal pre-decoding unit 4011.

The memory block local control unit 301 also includes a second local latch unit 4016. The input of the second local latch unit 4016 is coupled to the output of the selection module 304 and is configured to latch the first enable signal RedRowEnO. The output of the second local latch unit 4016 is coupled to the enable terminals of the row redundant pre-decoding unit 4012 and the row normal pre-decoding unit 4011.

When the test control signal Cm0_ts_RedTest=1, the multiplexer MUX outputs the decoding selection instruction input from the first input to the test enable latch unit 3041; after passing the test enable latch unit 3041, the first enable signal RedRowEnO is output to the memory block local control unit 301 for enabling the row normal pre-decoding unit 4011 or the row redundant pre-decoding unit 4012. When the locally latched first enable signal RedRowEn=1, the decoding of the normal path is stopped, and the row redundant pre-decoding unit 4012 is enabled; when the first enable signal RedRowEn=0, then the row redundant pre-decoding unit 4012 is stopped, and the normal decoding path will not be affected.

Corresponding to the column test, when performing the row test, one can control whether to perform redundant decoding or normal decoding on the row address signal through the decoding selection instruction in the address or command input signal.

In this specific embodiment, the local memory block control unit 301 further includes a row address comparison unit 4014; the input of the row address comparison unit 4014 is coupled to the input module 303, and the output of the row address comparison unit 4014 is coupled to the enable terminal of the row normal pre-decoding unit 4011 and the row redundant pre-decoding unit 4011.

The row address comparison unit 4014 is configured to store the defective address information acquired during the test. When performing normal reading and writing operations on the memory, the row address comparison unit 4014 compares the row address signal RowAdr<15:0> with the defective address information, and outputs a second enable signal RedRowRepair according to a result of the comparison, to control the decoding unit to perform corresponding redundant decoding or normal decoding on the address or command input signal. Specifically, when the access address matches the defective address, the second enable signal RedRowRepair=1, the access address is invalid, so as to enable the row redundant pre-decoding unit 4012to perform redundant pre-decoding on the input signal. to obtain the row address of the redundant memory unit that replaces the defective address; when the access address does not match the defective address, the access address is valid. When the second enable signal RedRowRepair=0, the row normal pre-decoding unit 4011 is enabled to perform row normal pre-decoding 4011 on the input signal to obtain the row address of the normal memory unit.

When performing normal reading and writing operations on the memory, the test control signal Cm0_ts_RedTest=0 can be set so that the selection module 304 does not obtain the decoding selection instruction, and the selection function of the selection module 304 for the redundant decoding path is stopped. At this time, it is possible that the decoding selection instruction is not set.

The embodiment of the present disclosure also provides an addressing method for the memory.

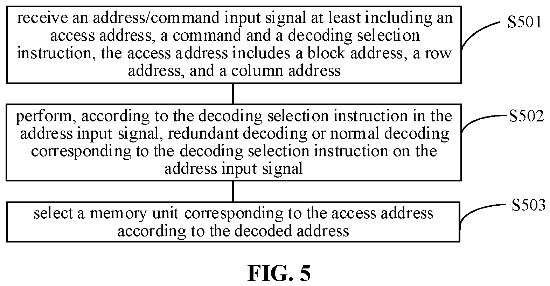

FIG.5 depicts the addressing method for a memory as the follows.

In Step S501, an address or command input signal is received, the address or command input signal includes at least an access address, a command, and a decoding selection instruction, where the access address includes a block address, a row address, and a column address.

The address or command input signal may be received through a plurality of input pins. The address or command input signal includes a plurality of sets of digital signals, wherein each set of the digital signals includes a plurality of electrical level signals input through the plurality of input pins. The decoding selection instruction is a level signal input from an input pin in a set of digital signals, and the decoding selection instruction corresponds to a decoding mode of the address or command input signal.

In Step S502, redundant decoding or normal decoding is performed on the address or command input signal corresponding to the decoding selection instruction according to the decoding selection instruction in the address or command input signal.

Here, the redundant decoding includes redundant pre-decoding and secondary decoding, and the normal decoding includes normal pre-decoding and secondary decoding.

By setting the decoding selection instruction, the corresponding decoding mode for the address or command input signal can be selected. For example, when the decoding selection instruction is 1, normal decoding is performed; when the decoding selection instruction is 0, redundant decoding is performed.

In Step S503, a memory unit corresponding to the access address is selected based on the decoded address.

The above steps can be applied to decode the row address and column address, respectively.

By setting the corresponding decoding selection instruction, one can switch the access to the redundant memory unit and the normal memory unit, making it more flexible in the testing process, meanwhile the control timing is consistent, avoiding human test errors and improving the test accuracy and flexibility.

The addressing method for the memory of the present disclosure further includes:
during normal use, comparing the access address in the address or command input signal with the defective address information, and performing relevant redundant decoding or normal decoding based on a result of the comparison. Specifically, when the access address matches the defective address, the access address is invalid, and redundant pre-decoding is performed on the input signal to obtain the address of the redundant memory unit that replaces the defective address. When the access address does not match the defective address, the access address is valid, and the input signal is normally decoded to obtain the address of the normal memory unit.

The above are only the preferred embodiments of the present disclosure. It should be pointed out that for those of ordinary skill in the art, without departing from the principle of the present disclosure, several improvements and modifications can be made, and these improvements and modifications should also be considered in the protection scope of the invention which is defined by the appended claims.

## Claims

1. A memory, comprising:
an input module (201, 303) for receiving an address or command input signal, wherein the address or command input signal includes an access address, a command, and a decoding selection instruction, wherein the access address includes a block address, a row address, and a column address;
a memory array (202) comprising a plurality of memory blocks, wherein each of the plurality of memory blocks includes a plurality of memory units arranged in an array;
a control module (203), wherein the control module (203) comprises a plurality of memory block local control units (301), wherein each of the plurality of memory block local control units (301) is connected to a respective one of the plurality of memory blocks, and is configured to decode the address or command input signal having a corresponding block address to select a memory unit corresponding to the access address wherein the plurality of memory block local control units (301) each includes at least one decoding unit, wherein the decoding unit is configured to perform redundant decoding or normal decoding on the address or command input signal, wherein an input of the decoding unit is coupled to the input module (201, 303), an output of the decoding unit is coupled to one of the plurality of memory units; and
**characterized in that**,
a selection module (204, 304) comprising a multiplexer and a test enable latch unit (3041), wherein a first input of the multiplexer coupled to the input module (201, 303), a second input coupled to a reference level, a control terminal coupled to a test control signal, and the reference level is a low level 0, wherein the test control signal is configured to control the multiplexer to output a signal corresponding to the first input or the second input of the multiplexer, wherein an input of the test enable latch unit (3041) is coupled to an output of the multiplexer, and an output of the selection module (204, 304) is coupled to the decoding unit, wherein the selection module (204, 304) is configured to, based on a clock signal (Clk), output a first enable signal (RedColEnO), to control the decoding unit to perform redundant decoding or normal decoding corresponding to the decoding selection instruction on the address or command input signal,
wherein the decoding unit comprises a redundant pre-decoding unit (3012, 4012), a normal pre-decoding unit (3011, 4011), and a secondary decoding unit (3013, 4013); wherein the output of the selection module (204, 304) is coupled to an enable terminal of the redundant pre-decoding unit (3012, 4012) and an enable terminal of the normal pre-decoding unit (3011, 4011); and wherein an output of the redundant pre-decoding unit (3012, 4012) and an output of the normal pre-decoding unit (3011, 4011) are both coupled to an input of the secondary decoding unit (3013, 4013);
wherein the input module (201, 303) comprises: an input interface, a buffer unit (3031) coupled to the input interface, a logic control unit (3032) coupled to an output of the buffer unit (3031), and a normal address latch unit (3033) coupled to an output of the logic control unit (3032);
wherein the normal address latch unit (3033) and the test enable latch unit (3041) are both controlled by the same clock signal (Clk);
wherein an output of the normal address latch unit (3033) is coupled to an input of the normal pre-decoding unit (3011, 4011) and an input of the redundant pre-decoding unit (3012, 4012);
wherein an output of the test enable latch unit (3041) is coupled to the enable terminal of the redundant pre-decoding unit (3012, 4012) and the enable terminal of the normal pre-decoding unit (3011, 4011); and
wherein the test enable latch unit (3041) is configured to output the first enable signal (RedColEnO) for enabling the normal pre-decoding unit (3011) or the redundant pre-decoding unit (3012) according to the decoding selection instruction in the address or command input signal corresponding to the first input of the multiplexer or the reference level corresponding to the second input of the multiplexer.

2. The memory according to claim 1, wherein each of the plurality of the memory block local control units (301) further comprises an address comparison unit (3014), wherein an input of the address comparison unit (3014) is coupled to the input module (201, 303), and an output of the address comparison unit (3014) is coupled to the decoding unit, wherein the address comparison unit (3014) is configured to store defective address information, compare the access address in the address or command input signal with the defective address information, and output a second enable signal based on the comparison, and wherein the second enable signal is configured to control the decoding unit to perform redundant decoding or normal decoding on the address or command input signal.

3. The memory according to claim 1, wherein each of the plurality of memory block local control units (301) further comprises a first local latch unit (3015, 4015), wherein an input of the first local latch unit (3015, 4015) is coupled to the output of the normal address latch unit (3033) of the input module (201, 303).

4. The memory of claim 1, wherein the input module (201, 303) comprises a plurality of input pins, wherein the address or command input signal comprises multiple sets of digital signals, wherein each set of the multiple sets of digital signals comprise a plurality of level signals input through a plurality of input pins, wherein the decoding selection instruction is a level signal, from one of the plurality of input pins, of one set of the multiple sets of digital signals, and the decoding selection instruction corresponds to a decoding mode for the address or command input signal.

5. The memory according to claim 1, wherein the decoding unit further comprises: a second local latch unit (3016, 4016), wherein an input of the second local latch unit (3016, 4016) is coupled to the output of the test enable latch unit (3041) of the selection module (204, 304).

6. The memory according to claim 1, wherein each of the plurality of memory block local control units (301) comprises two decoding units, wherein the two decoding units are configured to decode the row address and the column address, respectively, in the access address.

7. An addressing method for a memory according to claim 1, comprising:
receiving (S501) the address or command input signal;
**characterized by**,
performing (S502), based on the clock signal, redundant decoding or normal decoding corresponding to the decoding selection instruction on the address or command input signal according to the decoding selection instruction in the address or command input signal corresponding to the first input of the multiplexer or the reference level corresponding to the second input of the multiplexer output by the multiplexer; and
selecting (S503) a memory unit corresponding to the decoded access address.

8. The addressing method for the memory according to claim 7, wherein the redundant decoding comprises redundant pre-decoding and secondary decoding; and wherein the normal decoding includes normal pre-decoding and secondary decoding.

9. The addressing method for the memory according to claim 7, further comprising: comparing the access address in the address or command input signal with a defective address information in normal use of the memory, and performing redundant decoding or normal decoding on the address or command input signal according to a result of the comparison.

10. The addressing method for the memory according to claim 7, wherein the address or command input signal is received through a plurality of input pins, wherein the address or command input signal comprises a plurality of sets of digital signals, wherein each of the plurality of sets of digital signals include a plurality of level signals input through the plurality of input pins, and wherein the decoding selection instruction is one of the plurality of level signals, from one of the plurality of input pins, of one of the plurality of sets of digital signals, and wherein the decoding selection instruction corresponds to a decoding mode for the address or command input signal.

11. The addressing method for the memory according to any one of claims 7 to 10, further comprising decoding the row address and the column address separately in the address or command input signal.

## Patentansprüche

1. Speicher, umfassend:
ein Eingabemodul (201, 303) zum Empfangen eines Adress- oder Befehlseingabesignals, wobei das Adress- oder Befehlseingabesignal eine Zugriffsadresse, einen Befehl und eine Dekodierungsauswahlanweisung beinhaltet, wobei die Zugriffsadresse eine Blockadresse, eine Zeilenadresse und eine Spaltenadresse beinhaltet;
ein Speicherarray (202), umfassend eine Vielzahl von Speicherblöcken umfasst, wobei jeder der Vielzahl von Speicherblöcken eine Vielzahl von in einem Array angeordneten Speichereinheiten beinhaltet;
ein Steuermodul (203), wobei das Steuermodul (203) eine Vielzahl von lokalen Speicherblocksteuereinheiten (301) umfasst, wobei jede der Vielzahl von lokalen Speicherblocksteuereinheiten (301) mit einem jeweiligen der Vielzahl von Speicherblöcken verbunden ist und konfiguriert ist, um das Adress- oder Befehlseingangssignal mit einer entsprechenden Blockadresse zu dekodieren, um eine der Zugriffsadresse entsprechende Speichereinheit auszuwählen, wobei die Vielzahl von lokalen Speicherblocksteuereinheiten (301) jeweils mindestens eine Dekodiereinheit beinhalten, wobei die Dekodiereinheit konfiguriert ist, um eine redundante Dekodierung oder eine normale Dekodierung an dem Adress- oder Befehlseingangssignal auszuführen, wobei ein Eingang der Dekodiereinheit mit dem Eingangsmodul (201, 303) gekoppelt ist, ein Ausgang der Dekodiereinheit mit einer der Vielzahl von Speichereinheiten gekoppelt ist; und
**dadurch gekennzeichnet, dass**
ein Auswahlmodul (204, 304), umfassend einen Multiplexer und eine Testfreigabe-Zwischenspeichereinheit (3041) umfasst, wobei ein erster Eingang des Multiplexers mit dem Eingangsmodul (201, 303) gekoppelt ist, ein zweiter Eingang mit einem Referenzpegel gekoppelt ist, ein Steueranschluss mit einem Teststeuersignal gekoppelt ist, und der Referenzpegel ein niedriger Pegel 0 ist, wobei das Teststeuersignal konfiguriert ist, um den Multiplexer zu steuern, um ein Signal auszugeben, das dem ersten Eingang oder dem zweiten Eingang des Multiplexers entspricht, wobei ein Eingang der Testfreigabe-Zwischenspeichereinheit (3041) mit einem Ausgang des Multiplexers gekoppelt ist und ein Ausgang des Auswahlmoduls (204, 304) mit der Dekodiereinheit gekoppelt ist, wobei das Auswahlmodul (204, 304) konfiguriert ist, um basierend auf einem Taktsignal (Clk) ein erstes Freigabesignal (RedColEnO) auszugeben, um die Dekodiereinheit zu steuern, um eine redundante Dekodierung oder eine normale Dekodierung entsprechend der Dekodierauswahlanweisung an dem Adress- oder Befehlseingangssignal auszuführen,
wobei die Dekodiereinheit eine redundante Vordekodiereinheit (3012, 4012), eine normale Vordekodiereinheit (3011, 4011) und eine sekundäre Dekodiereinheit (3013, 4013) umfasst; wobei der Ausgang des Auswahlmoduls (204, 304) mit einem Freigabeanschluss der redundanten Vordekodiereinheit (3012, 4012) und einem Freigabeanschluss der normalen Vordekodiereinheit (3011, 4011) gekoppelt ist; und wobei ein Ausgang der redundanten Vordekodiereinheit (3012, 4012) und ein Ausgang der normalen Vordekodiereinheit (3011, 4011) beide mit einem Eingang der sekundären Dekodiereinheit (3013, 4013) gekoppelt sind;
wobei das Eingangsmodul (201, 303) Folgendes umfasst: eine Eingangsschnittstelle, eine mit der Eingangsschnittstelle gekoppelte Puffereinheit (3031), eine mit einem Ausgang der Puffereinheit (3031) gekoppelte Logiksteuereinheit (3032) und eine mit einem Ausgang der Logiksteuereinheit (3032) gekoppelte normale Adress-Zwischenspeichereinheit (3033);
wobei die normale Adress-Zwischenspeichereinheit (3033) und die Testfreigabe-Zwischenspeichereinheit (3041) beide durch das gleiche Taktsignal (Clk) gesteuert werden;
wobei ein Ausgang der normalen Adress-Zwischenspeichereinheit (3033) mit einem Eingang der normalen Vordekodiereinheit (3011,4011) und einem Eingang der redundanten Vordekodiereinheit (3012, 4012) gekoppelt ist;
wobei ein Ausgang der Testfreigabe-Zwischenspeichereinheit (3041) mit dem Freigabeanschluss der redundanten Vordekodiereinheit (3012, 4012) und dem Freigabeanschluss der normalen Vordekodiereinheit (3011, 4011) gekoppelt ist; und
wobei die Testfreigabe-Zwischenspeichereinheit (3041) konfiguriert ist, um das erste Freigabesignal (RedColEnO) zum Freigeben der normalen Vordekodiereinheit (3011) oder der redundanten Vordekodiereinheit (3012) entsprechend der Dekodierauswahlanweisung in dem Adress- oder Befehlseingangssignal, das dem ersten Eingang des Multiplexers entspricht, oder dem Referenzpegel, der dem zweiten Eingang des Multiplexers entspricht, ausgibt.

2. Speicher nach Anspruch 1, wobei jede der Vielzahl der lokalen Speicherblocksteuereinheiten (301) ferner eine Adressvergleichseinheit (3014) umfasst, wobei ein Eingang der Adressvergleichseinheit (3014) mit dem Eingangsmodul (201, 303) gekoppelt ist und ein Ausgang der Adressvergleichseinheit (3014) mit der Dekodiereinheit gekoppelt ist, wobei die Adressvergleichseinheit (3014) konfiguriert ist, um fehlerhafte Adressinformationen zu speichern, die Zugriffsadresse in dem Adress- oder Befehlseingangssignal mit den fehlerhaften Adressinformationen zu vergleichen und basierend auf dem Vergleich ein zweites Freigabesignal auszugeben, und wobei das zweite Freigabesignal konfiguriert ist, um die Dekodiereinheit zu steuern, um eine redundante Dekodierung oder eine normale Dekodierung an dem Adress- oder Befehlseingangssignal auszuführen.

3. Speicher nach Anspruch 1, wobei jede der Vielzahl von lokalen Speicherblocksteuereinheiten (301) ferner eine erste lokale Zwischenspeichereinheit (3015, 4015) umfasst, wobei ein Eingang der ersten lokalen Zwischenspeichereinheit (3015, 4015) mit dem Ausgang der normalen Adress-Zwischenspeichereinheit (3033) des Eingangsmoduls (201, 303) gekoppelt ist.

4. Speicher nach Anspruch 1, wobei das Eingangsmodul (201, 303) eine Vielzahl von Eingangskontakten umfasst, wobei das Adress- oder Befehlseingangssignal mehrere Sätze von Digitalsignalen umfasst, wobei jeder Satz der Vielzahl von Sätze von Digitalsignalen eine Vielzahl von Pegelsignalen umfasst, die über eine Vielzahl von Eingangskontakten eingegeben werden, wobei der Dekodierauswahlbefehl ein Pegelsignal von einem der Vielzahl von Eingangskontakten eines Satzes der Vielzahl von Sätze von Digitalsignalen ist und der Dekodierauswahlbefehl einem Dekodiermodus für das Adress- oder Befehlseingangssignal entspricht.

5. Speicher nach Anspruch 1, wobei die Dekodiereinheit ferner Folgendes umfasst: eine zweite lokale Zwischenspeichereinheit (3016, 4016), wobei ein Eingang der zweiten lokalen Zwischenspeichereinheit (3016, 4016) mit dem Ausgang der Testfreigabe-Zwischenspeichereinheit (3041) des Auswahlmoduls (204, 304) gekoppelt ist.

6. Speicher nach Anspruch 1, wobei jede der Vielzahl von lokalen Speicherblocksteuereinheiten (301) zwei Dekodiereinheiten umfasst, wobei die beiden Dekodiereinheiten konfiguriert sind, um die Zeilenadresse bzw. die Spaltenadresse in der Zugriffsadresse zu dekodieren.

7. Adressierungsverfahren für einen Speicher nach Anspruch 1, umfassend: Empfangen (S501) des Adress- oder Befehlseingangssignals; **gekennzeichnet durch** Ausführen (S502), basierend auf dem Taktsignal, eines redundanten Dekodierens oder eines normalen Dekodierens entsprechend der Dekodierauswahlanweisung an dem Adress- oder Befehlseingangssignal gemäß der Dekodierauswahlanweisung in dem Adress- oder Befehlseingangssignal, das dem ersten Eingang des Multiplexers entspricht, oder dem Referenzpegel, der dem zweiten Eingang des Multiplexers entspricht, der von dem Multiplexer ausgegeben wird; und Auswählen (S503) einer Speichereinheit, die der dekodierten Zugriffsadresse entspricht.

8. Adressierungsverfahren für den Speicher nach Anspruch 7, wobei die redundante Dekodierung redundante Vordekodierung und sekundäre Dekodierung umfasst; und wobei die normale Dekodierung normale Vordekodierung und sekundäre Dekodierung umfasst.

9. Adressierungsverfahren für den Speicher nach Anspruch 7, ferner umfassend: Vergleichen der Zugriffsadresse in dem Adress- oder Befehlseingangssignal mit fehlerhaften Adressinformationen bei normaler Verwendung des Speichers und Ausführen einer redundanten Dekodierung oder einer normalen Dekodierung an der Adresse oder dem Befehlseingangssignal gemäß einem Resultat des Vergleichs.

10. Adressierungsverfahren für den Speicher nach Anspruch 7, wobei das Adress- oder Befehlseingangssignal über eine Vielzahl von Eingangskontakten empfangen wird, wobei das Adress- oder Befehlseingangssignal eine Vielzahl von Sätzen von Digitalsignalen umfasst, wobei jeder der Vielzahl von Sätzen von Digitalsignalen eine Vielzahl von Pegelsignalen umfasst, die über die Vielzahl von Eingangskontakten eingegeben werden, und wobei die Dekodierauswahlanweisung eine der Vielzahl von Pegelsignalen von einem der Vielzahl von Eingangskontakten von einem der Vielzahl von Sätzen von Digitalsignalen ist, und wobei die Dekodierauswahlanweisung einem Dekodiermodus für das Adress- oder Befehlseingangssignal entspricht.

11. Adressierungsverfahren für den Speicher nach einem der Ansprüche 7 bis 10, wobei die Zeilenadresse und die Spaltenadresse in dem Adress- oder Befehlseingangssignal getrennt dekodiert sind.

## Revendications

1. Mémoire, comprenant :
un module d'entrée (201, 303) pour recevoir un signal d'entrée d'adresse ou d'ordre, dans laquelle le signal d'entrée d'adresse ou d'ordre comprend une adresse d'accès, un ordre et une instruction de sélection de décodage, dans laquelle l'adresse d'accès comprend une adresse de bloc, une adresse de ligne et une adresse de colonne ;
une matrice mémoire (202) comprenant une pluralité de blocs de mémoire, dans laquelle chacun de la pluralité de blocs de mémoire comprend une pluralité d'unités de mémoire disposées dans une matrice ;
un module de commande (203), dans laquelle le module de commande (203) comprend une pluralité d'unités de commande locale de bloc mémoire (301), dans laquelle chacune de la pluralité d'unités de commande locale de bloc mémoire (301) est connectée à un bloc mémoire respectif de la pluralité de blocs mémoire, et est configurée pour décoder le signal d'entrée d'adresse ou d'ordre ayant une adresse de bloc correspondante pour sélectionner une unité de mémoire correspondant à l'adresse d'accès, dans laquelle la pluralité d'unités de commande locale de bloc mémoire (301) comprend chacune au moins une unité de décodage, dans laquelle l'unité de décodage est configurée pour effectuer un décodage redondant ou un décodage normal sur le signal d'entrée d'adresse ou d'ordre, dans laquelle une entrée de l'unité de décodage est couplée au module d'entrée (201, 303), une sortie de l'unité de décodage est couplée à l'une de la pluralité d'unités de mémoire ; et
**caractérisée en ce que**,
un module de sélection (204, 304) comprenant un multiplexeur et une unité de verrouillage de validation de test (3041), dans laquelle une première entrée du multiplexeur couplée au module d'entrée (201, 303), une seconde entrée couplée à un niveau de référence, une borne de commande couplée à un signal de commande de test, et le niveau de référence est un niveau bas 0, dans laquelle le signal de commande de test est configuré pour commander au multiplexeur d'émettre un signal correspondant à la première entrée ou à la seconde entrée du multiplexeur, dans laquelle une entrée de l'unité de verrouillage de validation de test (3041) est couplée à une sortie du multiplexeur, et une sortie du module de sélection (204, 304) est couplée à l'unité de décodage, dans laquelle le module de sélection (204, 304) est configuré pour, sur la base d'un signal d'horloge (Clk), émettre un premier signal de validation (RedColEnO), afin de commander à l'unité de décodage d'effectuer un décodage redondant ou un décodage normal correspondant à l'instruction de sélection de décodage sur le signal d'entrée d'adresse ou d'ordre,
dans laquelle l'unité de décodage comprend une unité de prédécodage redondante (3012, 4012), une unité de prédécodage normale (3011, 4011) et une unité de décodage secondaire (3013, 4013) ; dans laquelle la sortie du module de sélection (204, 304) est couplée à une borne de validation de l'unité de prédécodage redondante (3012, 4012) et à une borne de validation de l'unité de prédécodage normale (3011, 4011) ; et dans laquelle une sortie de l'unité de prédécodage redondante (3012, 4012) et une sortie de l'unité de prédécodage normale (3011, 4011) sont toutes deux couplées à une entrée de l'unité de décodage secondaire (3013, 4013) ;
dans laquelle le module d'entrée (201, 303) comprend : une interface d'entrée, une unité tampon (3031) couplée à l'interface d'entrée, une unité de commande logique (3032) couplée à une sortie de l'unité tampon (3031), et une unité de verrouillage d'adresse normale (3033) couplée à une sortie de l'unité de commande logique (3032) ;
dans laquelle l'unité de verrouillage d'adresse normale (3033) et l'unité de verrouillage de validation de test (3041) sont toutes deux commandées par le même signal d'horloge (Clk) ;
dans laquelle une sortie de l'unité de verrouillage d'adresse normale (3033) est couplée à une entrée de l'unité de prédécodage normale (3011, 4011) et à une entrée de l'unité de prédécodage redondante (3012, 4012) ;
dans laquelle une sortie de l'unité de verrouillage de validation de test (3041) est couplée à la borne de validation de l'unité de prédécodage redondante (3012, 4012) et à la borne de validation de l'unité de prédécodage normale (3011, 4011) ; et
dans laquelle l'unité de verrouillage de validation de test (3041) est configurée pour émettre le premier signal de validation (RedColEnO) pour activer l'unité de prédécodage normale (3011) ou l'unité de prédécodage redondante (3012) selon l'instruction de sélection de décodage dans le signal d'entrée d'adresse ou d'ordre correspondant à la première entrée du multiplexeur ou le niveau de référence correspondant à la seconde entrée du multiplexeur.

2. Mémoire selon la revendication 1, dans laquelle chacune de la pluralité des unités de commande locale de bloc mémoire (301) comprend en outre une unité de comparaison d'adresses (3014), dans laquelle une entrée de l'unité de comparaison d'adresses (3014) est couplée au module d'entrée (201, 303), et une sortie de l'unité de comparaison d'adresses (3014) est couplée à l'unité de décodage, dans laquelle l'unité de comparaison d'adresses (3014) est configurée pour stocker des informations sur les adresses défectueuses, comparer l'adresse d'accès dans le signal d'entrée d'adresse ou d'ordre avec les informations sur les adresses défectueuses et émettre un second signal de validation sur la base de la comparaison, et dans laquelle le second signal de validation est configuré pour commander à l'unité de décodage d'effectuer un décodage redondant ou un décodage normal sur le signal d'entrée d'adresse ou d'ordre.

3. Mémoire selon la revendication 1, dans laquelle chacune de la pluralité d'unités de commande locale de blocs de mémoire (301) comprend en outre une première unité de verrouillage local (3015, 4015), dans laquelle une entrée de la première unité de verrouillage local (3015, 4015) est couplée à la sortie de l'unité de verrouillage d'adresse normale (3033) du module d'entrée (201, 303).

4. Mémoire selon la revendication 1, dans laquelle le module d'entrée (201, 303) comprend une pluralité de broches d'entrée, dans laquelle le signal d'entrée d'adresse ou d'ordre comprend plusieurs ensembles de signaux numériques, dans laquelle chaque ensemble des multiples ensembles de signaux numériques comprend une pluralité de signaux de niveau entrés par une pluralité de broches d'entrée, dans laquelle l'instruction de sélection de décodage est un signal de niveau, provenant de l'une de la pluralité de broches d'entrée, d'un ensemble des multiples ensembles de signaux numériques, et l'instruction de sélection de décodage correspond à un mode de décodage pour le signal d'entrée d'adresse ou d'ordre.

5. Mémoire selon la revendication 1, dans laquelle l'unité de décodage comprend en outre : une seconde unité de verrouillage local (3016, 4016), dans laquelle une entrée de la seconde unité de verrouillage local (3016, 4016) est couplée à la sortie de l'unité de verrouillage de validation de test (3041) du module de sélection (204, 304).

6. Mémoire selon la revendication 1, dans laquelle chacune de la pluralité d'unités de commande locale de bloc mémoire (301) comprend deux unités de décodage, dans laquelle les deux unités de décodage sont configurées pour décoder l'adresse de ligne et l'adresse de colonne, respectivement, dans l'adresse d'accès.

7. Procédé d'adressage d'une mémoire selon la revendication 1, comprenant : la réception (S501) du signal d'entrée d'adresse ou d'ordre ; **caractérisé par** l'exécution (S502), sur la base du signal d'horloge, d'un décodage redondant ou d'un décodage normal correspondant à l'instruction de sélection de décodage sur le signal d'entrée d'adresse ou d'ordre selon l'instruction de sélection de décodage dans le signal d'entrée d'adresse ou d'ordre correspondant à la première entrée du multiplexeur ou au niveau de référence correspondant à la seconde entrée du multiplexeur émise par le multiplexeur ; et la sélection (S503) d'une unité de mémoire correspondant à l'adresse d'accès décodée.

8. Procédé d'adressage de la mémoire selon la revendication 7, dans lequel le décodage redondant comprend un prédécodage redondant et un décodage secondaire ; et dans lequel le décodage normal comprend un prédécodage normal et un décodage secondaire.

9. Procédé d'adressage de la mémoire selon la revendication 7, comprenant en outre : la comparaison de l'adresse d'accès dans le signal d'entrée d'adresse ou d'ordre à une information d'adresse défectueuse dans l'utilisation normale de la mémoire, et l'exécution d'un décodage redondant ou d'un décodage normal sur le signal d'entrée d'adresse ou d'ordre en fonction d'un résultat de la comparaison.

10. Procédé d'adressage de la mémoire selon la revendication 7, dans lequel le signal d'entrée d'adresse ou d'ordre est reçu par une pluralité de broches d'entrée, dans lequel le signal d'entrée d'adresse ou d'ordre comprend une pluralité d'ensembles de signaux numériques, dans lequel chacun de la pluralité d'ensembles de signaux numériques comprend une pluralité de signaux de niveau entrés par la pluralité de broches d'entrée, et dans lequel l'instruction de sélection de décodage est l'un de la pluralité de signaux de niveau, provenant de l'une de la pluralité de broches d'entrée, de l'un de la pluralité d'ensembles de signaux numériques, et dans lequel l'instruction de sélection de décodage correspond à un mode de décodage pour le signal d'entrée d'adresse ou d'ordre.

11. Procédé d'adressage de la mémoire selon l'une quelconque des revendications 7 à 10, comprenant en outre le décodage de l'adresse de ligne et de l'adresse de colonne séparément dans le signal d'entrée d'adresse ou d'ordre.
